Europäisches Patentamt

European Patent Office

Office européen des brevets

(11) Numéro de publication: **0 248 779**
**A1**

# DEMANDE DE BREVET EUROPEEN

(21) Numéro de dépôt: **87870061.6**

(22) Date de dépôt: **06.05.87**

(51) Int. Cl.⁴: **G 03 F 7/26**

(30) Priorité: **08.05.86 GB 8611229**

(43) Date de publication de la demande:
**09.12.87 Bulletin 87/50**

(84) Etats contractants désignés:
**AT BE CH DE ES FR GB GR IT LI LU NL SE**

(71) Demandeur: **U C B**
**326, Avenue Louise**
**B-1050 Bruxelles (BE)**

(72) Inventeur: **Roland, Bruno**
**120, Waverse Baan**
**B-3030 Heverlee (BE)**

**Vrancken, August**
**5A, Matenstraat**
**B-3600 Genk (BE)**

(74) Mandataire: **Dusseldorp, Raymond et al**
**U.C.B. S.A. Département D.T.B. 326, avenue Louise, Bte 7**
**B-1050 Bruxelles (BE)**

(54) **Procédé de formation de motifs positifs dans une couche de photorésist.**

(57) Ce procédé comporte les stades suivants: (a) le recouvrement d'un substrat par une couche de résine photosensible comprenant un polymère porteur de groupes fonctionnels, de préférence phénolique, mélangé ou lié à un agent de réticulation photosensible, tel qu'un bis-arylazide, (b) l'exposition à la lumière visible ou ultraviolette de la couche à travers un masque, (c) le traitement de la couche par un composé de silicium (p.e. hexaméthyldisilazane) et (d) le développement par voie sèche par gravure au plasma (p.e. un plasma d'oxygène), pour enlever les parties irradiées de la couche. Le composé de silicium diffuse sélectivement dans les parties non irradiées de la couche et se fixe dans ces parties; par la gravure sèche, il se forme un masque d'oxyde de silicium qui protège ces parties non irradiées pendant cette opération.
Application à la fabrication de circuit intégrés.

EP 0 248 779 A1

## Description

Procédé de formation de motifs positifs dans une couche de photorésist.

La présente invention concerne un nouveau procédé microlithographique. Elle se rapporte plus particulièrement à un procédé de formation de motifs positifs dans une couche de photorésist permettant la production à l'échelle industrielle avec un rendement élevé de microcircuits à très grande intégration (VLSI) dont la largeur des lignes peut descendre jusqu'en-dessous du micromètre. La présente invention a également pour objet l'utilisation de ce nouveau procédé pour la fabrication de circuits semi-conducteurs intégrés.

La tendance actuelle vers la miniaturisation dans le domaine des circuits semi-conducteurs intégrés crée la nécessité d'adapter plus de circuits actifs par unité de surface sur la surface d'un cristal de semiconducteur.

A titre d'exemple, on prendra en considération le développement commercial des dispositifs à mémoire à accès aléatoire (RAM) de semi-conducteur à grille isolée par oxyde métallique (MOS) évoluant de 1 Kbit en 1975 via 16 Kbits en 1977 et 64 Kbits en 1979 à 256 Kbits en 1982. On s'attend à ce que cette tendance se poursuive au cours des deux décennies suivantes. Par conséquent, on s'attend à ce que la dimension minimale des caractéristiques des dispositifs semi-conducteurs à décroître de 8 micromètres pour les dispositifs RAM MOS de 1 Kbit à 2 micromètres pour les dispositifs RAM MOS de 256 Kbits en 1982 jusqu'en-dessous de 1 micromètre avant la fin des années 80.

La fabrication de microcircuits requiert la diffusion sélective de petites quantités contrôlées d'impuretés dans des régions spécifiques de la surface du semi-conducteur pour produire les caractéristiques électriques désirées du circuit, telles que des éléments de transistor et d'autres éléments dont un circuit à très grande intégration contient plusieurs dizaines de milliers d'unités individuelles interconnectées de manière complexe par des conducteurs tels que de l'aluminium ou du silicium polycristallin fortement dopé.

La technique utilisée dans la production commerciale de circuits intégrés pour obtenir des motifs spécifiques est appelée photolithographie ou microlithographie. On recouvre le substrat de silicium (tranche) éventuellement oxydé, d'une couche de résine photosensible, également appelée photorésist, ou plus simplement résist, et on l'expose à travers un masque à de la lumière ultraviolette. Les propriétés chimiques et physiques des régions irradiées sont différentes des régions non irradiées et créent la possibilité d'enlever lors d'une étape de développement la partie exposée (dans une résine positive) ou la partie non exposée (dans une résine négative).

Les procédés de développement sont principalement basés sur des différences de solubilité et sont réalisés par une technique par voie humide. Après enlèvement d'une partie de la couche de résist, la surface dénudée du substrat peut être traitée (gravée, dopée, oxydée, traitée au nitrure, plaquée, etc.).

On répète ce procédé photolithographique (plus de dix fois) avant de réaliser les géometries de circuit tridimensionnelles nécessaires pour un dispositif de semi-conducteur à grille isolée par oxyde métallique (MOS) ou bipolaire. La structure d'un circuit intégré est complexe à la fois en ce qui concerne la topographie de sa surface et sa composition interne. Chaque élément de ce dispositif a une architecture tridimensionnelle complexe qui doit être reproduite exactement dans chaque circuit. La structure est constituée d'un grand nombre de couches, dont chacune est une image détaillée. Certaines des couches se situent à l'intérieur de la tranche de silicium et d'autres sont rassemblées en surface. Le procédé est décrit dans l'ouvrage de L.F. THOMPSON, C.G. WILSON et M.J. BOWDEN "Introduction to Microlithography", American Chemical Society Symposium, Series 219, Amer. Chem. Soc., Washington D.C., 1983.

Comme conséquence de la densité d'intégration croissante des circuits, la dimension minimale des caractéristiques des dispositifs semi-conducteurs diminue et les procédés de fabrication deviennent plus difficiles. L'obtention d'une haute résolution avec un bon contrôle de la largeur des lignes sur des substrats présentant une topographie de surface est un sérieux problème. Par suite de réflexions optiques et de variations d'épaisseur du résist sur des gradins élevés, le contrôle de la largeur des lignes devient très difficile et des courches de résist relativement épaisses sont nécessaires. Etant donné que pour ces petites caractéristiques, les dimensions latérales s'amenuisent plus rapidement que les dimensions verticales, il faut des rapports d'aspect de la hauteur à la largeur plus élevés pour les images de résist. De plus, les techniques de gravure sèche requièrent des images de résist relativement épaisses et stables. Toutefois, les couches épaisses de résist limitent la résolution et créent des problèmes de profondeur de champ pour l'impression par projection. En outre, le gonflement des résists négatifs dans les révélateurs à base de solvants organiques les rend inappropriés pour une microlithographie à haute résolution et limite le choix aux résists à action positive contenant des diazoquinones. Mais même ces résists à contraste élevé et à haute résolution deviennent insuffisants lorsque les largeurs des lignes diminuent vers les régions du micromètre et en-dessous du micromètre.

Plusieurs méthodes pour obtenir une résolution plus élevée et un meilleur contrôle de la largeur des lignes ont été développées au cours de ces dernières années. De nouvelles techniques d'exposition ont été étudiées, telles que l'impression par faisceaux d'électrons, l'exposition aux rayons X et aux rayons ultraviolets lointains. La lithographie par faisceaux d'électrons requiert un équipement très coûteux; elle présente en outre l'inconvénient d'un faible taux de production et ne permet pas de produire des rapports d'aspect élevées à cause de la rétrodiffusion d'électrons: effet que l'on appelle effet de proximité. L'exposition aux rayons X permet d'atteindre des résolutions très élevés mais l'équipement et les résists sont encore au stade préindustriel. En outre, la fabrication de masques pour la lithographie aux rayons X est une opération difficile. L'utilisation de lumière UV lointaine diminue les effets de diffraction, mais la résolution est encore limitée par le gonflement des résists négatifs, et des résists positifs pour l'UV lointain ayant une sensibilité suffisante, ne sont pas encore disponibles.

Pour remédier aux effets défavorables des solvants au cours du développement par voie humide, on a déjà envisagé de développer les photorésists par plasma (cf. J.N. SMITH, H.G. HUGHES, J.V. KELLER, W.R. GOODNER et T.E. WOOD, dans Semiconductor International,2,(1979,no10, Décembre),p.41-47. Le développement par voie sèche des résists constitue un pas important vers un procédé de microfabrication totalement sec, offrant un contrôle opérationnel, une reproductibilité et une propreté meilleurs. De plus, le développement par voie sèche résout des problèmes tels que la perte de résolution par gonflement (en particulier dans le cas des résists négatifs) et la manipulation de grandes quantités de solvants inorganiques ou organiques. Il présente également une bien meilleure adaptabilité aux procédés de fabrication en chaîne automatique. Toutefois, la plupart des systèmes de résist destinés au développement par voie sèche ont un faible contraste et subissent une diminution importante de leur épaisseur au cours du développement.

Un autre moyen pour obtenir une haute résolution et un rapport d'aspect élevé est d'utiliser des systèmes de résist à couches multiples. Dans ces procédés, un excellent recouvrement des gradins et une excellente résistance à la gravure sèche d'une couche inférieure aplanissante épaisse sont combinés avec la haute résolution d'une mince couche supérieure de formation d'images. Les deux couches peuvent être optimalisées en ce qui concerne leurs exigences spécifiques. Après exposition et développement de la mince couche supérieure de résist, les motifs obtenus sont transférés presque verticalement dans l'épaisse couche sous-jacente, soit par exposition à un rayonnement ultraviolet lointain et développement, soit par gravure par ions réactifs d'oxygène. Pour cette dernière méthode, une troisième couche intermédiaire est intercalée entre la couche de formation d'images et la couche aplanissante. Habituellement, on fait appel à une couche d'oxyde de silicium appliquée par centrifugation ou déposée par plasma sur la surface de la couche aplanissante. Les images exposées et développées dans la couche supérieure de résist sont transférées dans la couche intermédiaire (oxyde de silicium) par des techniques de gravure sèche. Après enlèvement de la couche de résist, les motifs très fins d'oxyde de silicium servent de masque très efficace pour la gravure par ions réactifs d'oxygène de la couche inférieure épaisse, conduisant à des profils avec des parois latérales presque verticales. On a utilisé également comme couche intermédiaire de l'aluminium ou du nitrure de silicium.

Avec ces techniques, on peut obtenir une haute résolution et des rapports d'aspect élevés sur des substrats présentant une topographie de surface (cf. J.M. MORAN et D. MAYDAN dans The Bell System Technical Journal, 58,(1979, no5, mai-juin, p.1027-1036).

Les systèmes de résist multicouches présentent cependant également un certain nombre d'inconvénients. Ainsi, il se forme des couches interfaciales lorsque l'on applique par centrifugation une matière polymère sur une autre. Des étapes de cuisson intense peuvent réduire quelque peu ce phénomène mais, même dans ce cas, des traitements supplémentaires sont nécessaires pour enlever ces couches avant le transfert des motifs. La cuisson peut cependant provoquer des tensions sur le film. Les films d'oxyde de silicium appliqués par centrifugation sont très susceptibles de se fissurer lorsque la température de cuisson est trop élevée. D'un autre côté, une température de cuisson suffisamment élevée est nécessaire pour éviter un mélange interfacial entre l'oxyde et la couche de formation d'images.

Un autre problème réside dans les effets d'interférence optique. Même avec une couche inférieure fortement absorbante, des réflexions peuvent se produire aux interfaces conduisant à des ondes stationnaires. Une cuisson post-exposition de la couche de formation d'images peut réduire ces effets, mais uniquement aux dépens d'une perte de contraste.

Finalement, les minces couches supérieures de résist que l'on utilise dans les systèmes multicouches pour produire de meilleures images rendent le système plus sensible aux problèmes de formation de piqûres. Des systèmes de résist multicouches sont décrits en détail par B.J. LIN dans l'ouvrage "Introduction to Microlithography", dont question ci-dessus, p.287-350.

Un autre inconvénient majeur des systèmes multicouches est la complexité du procédé. Plusieurs couches doivent être appliquées et cuites, et chacune d'entre elles doit être exposée, développée et/ou gravée. C'est pourquoi des efforts ont récemment été faits pour simplifier ces systèmes multicouches, sans pour autant perdre leurs avantages. Un exemple est le procédé de gravure par ions réactifs (RIE) à deux couches, dans lequel la couche supérieure de formation d'images est un résist contenant des composants à la fois organique et inorganique, comme par exemple du poly(diméthyl siloxane) et du poly(vinyl-méthyl siloxane) (cf. M. HATZAKIS et coll. dans Proceedings of the International Conference on Microlithography,1981, p.386-396) des copolymères de chlorométhylstyrène et de triméthylsilylstyrène (cf. M. SUZUKI et coll., dans J. Electrochem.Soc.130,(1983)p.1962-1964)et des copolymères de vinyltriméthylsilane et de dioxyde de soufre (brevet américain 4.357.369). La mince couche supérieure de résist est exposée et développée, suivi d'une gravure de l'épaisse couche inférieure par ions réactifs d'oxygène. Au cours de ce procédé, les composants inorganiques dans le résist forment des oxydes réfractaires qui agissent à la manière d'un masque de gravure formé in situ. De cette manière, la couche supérieure de formation d'images et la couche intermédiaire d'oxyde de silicum du système de résist à trois couches, sont combinées en une seule couche de résist organométallique. Le traitement de ces systèmes est plus facile que ceux à trois couches mais encore toujours plus complexe que les systèmes à une seule couche. Jusqu'à présent, ils n'ont été mis au point que pour l'exposition aux faisceaux d'électrons et à L'UV lointain, et ils requièrent encore toujours un développement par voie humide dans des solvants organiques. Un autre exemple de système multicouches simplifié réside dans l'emploi d'une couche permettant d'augmenter le contraste. Dans ce procédé, une mince couche photoblanchissable est appliquée sur un photorésist positif standard. Au cours de l'exposition, le colorant dans le couche ainsi appliquée se décolore, en formant un nouveau masque en contact intime avec la surface du résist. Après exposition, on enlève la couche dans un système solvant et on traite le résist ensuite par des techniques conventionnelles. Bien que ce procédé améliore le contraste et n'augmente que légèrement la complexité du procédé, il ne résout pas le problème des ondes stationnaires et des variations de la largeur des lignes sur les gradins. De plus, il faut des temps d'exposition prolongés.

L'idéal serait évidemment de pouvoir disposer d'un système de résist à une seule couche offrant les mêmes avantages techniques que les sytèmes de résist multicouches, mais ne présentant pas leurs inconvénients. De cette manière, on supprimerait la formation de couches interfaciales, les effets d'interférence optique et les problèmes des tensions sur le film et on réduirait drastiquement la complexité du procédé.

Mais la difficulté est de trouver un système de résist à une seule couche, qui peut être développé par voie sèche et qui se caractérise en même temps par une haute résolution, des rapports d'aspect élevés et un excellent contrôle de la largeur des lignes sur des substrats présentant une topographie de surface, de manière à obtenir des motifs de résist d'excellente qualité permettent la fabrication avec une bonne reproductibilité de circuits semi-conducteurs à très grande intégration.

C'est pourquoi différentes tentatives ont été faites pour améliorer les systèmes de résist à une seule couche. Ainsi, par exemple, T.M. WOLF et coll. dans J.Electrochem.Soc.131,(1984,n°7),p.1664-1670), ont proposé un procédé destiné à améliorer les systèmes de résist à une seule couche. Les photorésists employés par ces auteurs sont des photorésists négatifs conventionnellement utilisés en photolithographie. Ils sont constitués par du polyisoprène partiellement cyclisé contenant un bis-azide comme photosensibilisateur (WAYCOAT IC-43 et SELECTILUX N-60 du commerce). Le procédé proposé comporte une étape d'exposition par irradiation ultraviolette ou par faisceaux d'électrons, une étape de traitement avec un halogénure inorganique volatil, suivie d'une étape de développement par gravure par ions réactifs d'oxygène. Dans les expériences décrites, ces auteurs emploient comme halogénures inorganiques volatils, le tétrachlorure de silicum (SiCl$_4$), le tétrachlorure d'étain (SnCl$_4$) et le dichlorodiméthylsilene ((CH$_3$)$_2$SiCl$_2$), parce que ces composés sont susceptibles de réagir avec les amines secondaires formées lors de la photolyse du résist. Ils espéraient en effect que cette réaction pourrait être mis à profit pour incorporer les halogénures inorganiques sélectivement dans les zones exposées du résist autorisant ainsi, lors de l'étape suivante de développement par gravure par ions réactifs d'oxygène, la formation par oxydation d'une épaisse couche de protection d'oxyde inorganique dans lesdites zones exposées. Ainsi, seules les zones non exposées du photorésist seraient enlevées sélectivement par la gravure par ions réactifs d'oxygène.

Toutefois, ils constatent que les composés inorganiques sont absorbés rapidement, non seulement dans les zones exposées, mais également dans les zones non exposées du résist.

En outre, ils observent que, contre toute attente, par gravure par ions réactifs d'oxygène, les zones non exposées du photorésist sont protégées par une couche d'oxyde et gravées à une vitesse beaucoup plus faible que les zones exposées, tandis que les zones exposées sont enlevées sélectivement au cours de l'étape de développement par gravure sèche. Autrement dit, le photorésist se comporte comme un résist de type positif. Les auteurs expliquent ce phénomène par le fait qu'il se forme aussi dans les zones non exposées des complexes entre l'halogénure inorganique et le groupe azide du photosensibilisateur pendant que dans les zones exposées, il se produit la zones non exposées, les complexes formés sont rapidement hydrolysés par la vapeur d'eau présente dans l'atmosphère ambiante et transformés en oxydes inorganiques réfractaires pendant l'opération de gravure par ions réactifs d'oxygène, formant ainsi une couche de protection in situ, alors que les produits de réaction formés dans les zones exposées sont moins rapidement hydrolysés et dès lors rapidement éliminés sous forme de composés volatils pendant l'opération de gravure par ions réactifs d'oxygène.

Il y a lieu de noter cependant que ce procédé présente encore des inconvénients importants.

En premier lieu, d'après les propres explications des auteurs, ce procédé ne donne satisfaction qu'à condition de respecter des durées très strictes d'exposition à la lumière et en même temps des durées très strictes de traitement avec l'halogénure inorganique. En effet, pour obtenir un résultat satisfaisant, il est nécessaire que l'exposition à la lumière du photorésist se fasse pendant 16 secondes et que le traitement avec l'halogénure inorganique se fasse pendant 7 secondes. Des durées d'exposition et/ou de traitement plus courtes ou plus longues fournissent des résultats peu satisfaisants. Ainsi, par exemple, après un traitement avec l'halogénure inorganique pendant 10 secondes, il n'est plus possible de développer le résist par gravure et ce quelle que soit le durée d'exposition à la lumière. En d'autres termes, les conditions opératoires sont très critiques, ce qui ne peut qu'être préjudiciable pour la reproductibilité des résultats.

En second lieu, même dans les conditions optimales citées ci-dessus, il subsiste après développement par gravure sèche, 70% seulement de l'épaisseur initiale du photorésist.

En troisième lieu, comme le montre la figure 11 à la page 1669 de l'article, il reste après développement, dans les zones dénudées, un résidu important qu'il est très difficile d'éliminer (ceci démontre en même temps que la sélectivité du procédé est insuffisante).

Dans la demande de brevet européen 85870142.8 au nom de la demanderesse, déposée le 24 octobre 1985, on propose un procédé microlithographique à une seule couche beaucoup plus perfectionné. Selon ce procédé, on forme des motifs négatifs dans une couche de photorésist; il comporte essentiellement les stades suivants:

(a) le recouvrement d'un substrat par une couche de résine photosensible comprenant un polymère mélangé ou attaché par une liaison chimique à un composé photosensible, ladite couche ayant la propriété de permettre à un composé de silicium de diffuser sélectivement dans ses parties irradiées lorsqu'elle a été exposée à un rayonnement visible ou ultraviolet dans lesdites parties;

(b) l'exposition à de la lumière ultraviolette ou visible de la couche de résine photosensible à travers un masque, de façon à ce que seules les parties voulues de la couche soient exposées;

(c) le traitement de la couche de résine photosensible par un composé de silicium, de manière à ce que ce composé soit sélectivement absorbé dans les parties irradiées de la couche et entre en réaction avec la résine photosensible dans lesdites parties irradiées; et

(d) le développement par voie sèche par gravure au plasma de la couche de résine photosensible ainsi traitée, de manière à enlever sélectivement les parties non irradiées de celle-ci pour obtenir les motifs négatifs souhaités.

Le procédé de cette demande de brevet européen repose sur la découverte que les résines photosensibles, mettant en jeu un polymère phénolique associé à un composé photosensible, tel qu'une diazoquinone, subissent des modifications substantielles de leurs propriétés de perméabilité sous l'influence d'un rayonnement visible ou ultraviolet. On a observé en effet que lorsqu'une couche irradiée de ces résines est soumise à un traitement par un composé de silicium, ce composé diffuse sélectivement dans les parties irradiées de la couche, alors qu'une telle diffusion ne se produit pratiquement pas dans les parties non irradiées, ou seulement de façon insignifiante.

Ceci a pour conséquence que le composé de silicium ne se fixe que dans les parties irradiées de la couche, où il entre en réaction avec les groupes hydroxyles phénoliques de la résine photosensible et qu'après développement par gravure par plasma, les parties non irradiées sont complètement éliminées, alors que, dans les parties irradiées, il se forme très rapidement un masque d'oxyde de silicium in situ qui subsiste et protège efficacement ces parties pendant toute l'opération de gravure.

Le résultat global est une différenciation nette entre les parties irradiées et les parties non irradiées de la couche de photorésist.

Ce procédé présente des avantages considérables par rapport à l'état de la technique. Tout d'abord, il possède tous les avantages et la simplicité de la microlithographie à une seule couche, autorise l'usage des techniques de gravure sèche et peut être utilisé sur un équipment courant d'impression par projection tout en produisant une résolution en-dessous du micromètre au moins égale, voire supérieure à celle des procédés multicouches susmentionnés.

En outre, les défauts du procédé de T.M. WOLF et coll., rappelés plus haut, sont définitivement supprimés.

Après développement, l'épaisseur des motifs obtenus est pratiquement identique à l'épaisseur initiale du photorésist; l'épaisseur résiduelle représente en général plus de 95% de l'épaisseur initiale de la couche de résine déposée sur le substrat. Dans les zones dénudées, il ne subsiste aucun résidu. De plus, la reproductibilité est considérablement améliorée.

Cependant, on notera que le procédé de la demande de brevet européen qui vient d'être décrit ci-dessus, procure exclusivement des motifs négatifs.

C'est pourquoi, il subsiste un besoin de mettre au point un procédé microlithographique à une seule couche qui permet la formation de motifs positifs dans une couche de photorésist, tout en conservant intégralement les avantages du procédé faisant l'objet de la demande de brevet européen 85870142.8. La demanderesse a atteint pleinement cet objectif avec le procédé décrit ci-après constituant l'objet de la présente invention.

La présente invention se rapporte donc à un nouveau procédé microlithographique. De façon plus spécifique, le présente invention procure un procédé de formation de motifs positifs dans une couche de photorésist caractérisé en ce qu'il comprend les stades suivants:

(a) Le recouvrement d'un substrat par une couche de résine photosensible comprenant un polymère porteur de groupes fonctionnels, mélangé ou lié chimiquement à un agent de réticulation photosensible, ladite résine photosensible étant telle que par un rayonnement visible ou ultraviolet, les parties irradiées de la couche subissent une réticulation qui supprime substantiellement le perméabilité desdites parties;

(b) L'exposition à la lumière ultraviolette ou visible de la couche de résine photosensible à travers un masque de façon à ce que seules les parties voulues de la couche soient exposées et à ce que sa perméabilité soit substantiellement supprimée dans lesdites parties;

(c) Le traitement de la couche de résine photosensible par un composé de silicium, de manière à ce que ce composé soit sélectivement absorbé dans les parties non irradiées de la couche et entre en réaction avec la résine photosensible dans lesdites parties non irradiées; et

(d) Le développement par voie sèche par gravure au plasma de la couche de résine photosensible ainsi traitée, de manière à enlever sélectivement les parties irradiées de celle-ci pour obtenir les motifs positifs souhaités.

Selon une forme de réalisation préférée de la présente invention, le substrat est une plaquette de silicium, le rayonnement appliqué est un rayonnement ultraviolet "proche" (350-450 nanomètres), la résine photosensible utilisée comprend un polymère phénolique et l'agent de réticulation photosensible qui lui est mélangé ou lié chimiquement est un bis-arylazide, tandis que le composé de silicium est un agent de silylation facilement vaporisable.

Par ailleurs, selon la présente invention, le traitement par le composé de silicium est, de préférence, exécuté après l'exposition de la couche de résine photosensible à la lumière ultraviolette ou visible. Toutefois, l'homme de métier comprendra que, dans un but de simplicité et de rapidité d'exécution, il est possible d'effectuer le traitement par le composé de silicium déjà au cours de l'exposition à la lumière de la couche de résine photosensible. Autrement dit, il est possible d'exécuter les stades (a) et (b) du procédé simultanément.

Suivant une forme de réalisation particulièrement préférée, le composé de silicium est volatilisé et mis en contact sous forme de vapeurs avec la couche de résine photosensible.

Selon une forme de réalisation particulièrement avantageuse de la présente invention, le développement par voie sèche est effectué par gravure au plasma d'oxygène ou par ions réactifs d'oxygène.

La présente invention comprend en outre l'utilisation du nouveau procédé microlithographique pour la fabrication de circuits semi-conducteurs intégrés.

Dans la présente spécification, on entend par "perméabilité", la propriété que possède la résine photosensible de laisser diffuser un composé de silicium au travers d'elle dans les conditions utilisées lors du traitement de cette résine par le composé de silicium.

La caractéristique essentielle du procédé de la présente invention réside dans l'emploi d'une résine photosensible réticulable qui possède cette perméabilité sous sa forme initiale, mais qui perd substantiellement cette perméabilité lorsqu'elle est réticulée sous l'effet d'un rayonnement visible ou ultraviolet.

Dans le procédé de la présente invention, à la différence du procédé décrit dans la demande de brevet européen 85870142.8, l'exposition à la lumière ultraviolette ou visible n'engendre donc pas la perméabilité de la couche de résine photosensible mais au contraire, cette exposition supprime substantiellement cette perméabilité dans les parties irradiées de la couche. Ceci a pour conséquence que lorsque la couche irradiée est soumise ensuite à un traitement par un composé de silicium, ce composé diffuse sélectivement dans les parties non irradiées (dont la perméabilité n'a subi aucune modification) et se fixe dans ces parties en entrant en réaction avec les groupes fonctionnels de la résine photosensible, par exemple avec les groupes hydroxyles phénoliques, lorsqu'on emploie un polymère phénolique. Par contre, dans les parties irradiées de la couche, une diffusion du composé de silicium ne se produit pratiquement pas, ou seulement de façon insignifiante.

Grâce à cette incorporation sélective du composé de silicium dans les parties irradiées de la couche, ces parties sont nettement plus résistantes à la gravure par plasma que les parties irradiées. En effet, au cours du développement par gravure sèche au plasma d'oxygène, il se forme très rapidement un masque d'oxyde de silicium in situ qui protège très efficacement ces parties pendant toute l'opération de gravure, tandis que les parties irradiées, exemple de composé de silicium, sont complètement éliminées.

Après développement, on obtient finalement d'excellents motifs positifs à haute résolution dans la couche de photorésist.

Il est à noter aussi que, contrairement au procédé de T.M. WOLF et coll., décrit plus haut, les composés de silicium ne diffusent pas dans toutes les parties de la couche de photorésist, mais uniquement dans les parties non irradiées.

Tout comme le procédé de la demande de brevet européen 85870142.8, le procédé de la présente invention se distingue donc nettement du procédé de l'état de la technique en raison du fait que ces deux procédés reposent sur une diffusion sélective des composés de silicium soit dans les parties irradiées du photorésist (dans le procédé de la demande de brevet européen 85870142.8), soit dans les parties non irradiées (dans le procédé de la présente invention), alors que le procédé de l'état de la technique repose exclusivement sur des réactions chimiques sélectives des composés de silicium avec le photosensibilisateur se produisant soit dans les parties irradiées, soit dans les parties non irradiées, les composés de silicium étant incorporés dans toutes les parties du photorésist.

L'avantage primordial du procédé conforme à l'invention par rapport au procédé de T.M. WOLF et coll. est que, après développement par gravure sèche par plasma, on obtient des motifs de qualité supérieure. En outre, on obtient des surfaces exemptes de résidu dans les zones dénudées. De plus, la reproductibilité est sensiblement améliorée.

Ainsi, la présente invention procure un système de résist à une seule couche qui peut être développé par voie sèche et qui possède tous les avantages des résists multicouches: aplanissement, haute résolution, des rapports d'aspect élevés avec une excellente rétention de l'épaisseur initiale de la couche de résine photosensible déposée sur le substrat, un bon contrôle de la largeur des lignes sur les gradins, une bonne reproductibilité des caractéristiques des motifs et la suppression de l'interférence avec la lumière réfléchie sur la topographie du substrat. De plus, le système décrit comporte plusieurs avantages par rapport aux systèmes de résist multicouches. Il ne se forme pas de couches interfaciales, il ne se produit pas d'interférence avec la lumière réfléchie, les problèmes des tensions sur le film n'existent pas et la complexité du procédé est réduite d'une manière draconienne.

La présente invention sera à présente décrit ci-après plus en détail en se référant au dessin d'accompagnement dans lequel les mêmes numéros de référence se réfèrent à des éléments similaires dans les différentes figures, les couches étant représentées à une échelle fortement exagérée.

La figure 1 est une vue en coupe transversale partielle d'une tranche de silicium recouverte d'une couche de résine photosensible avant le stade d'exposition.

La figure 2 est une vue en coupe transversale partielle d'une tranche de silicium recouverte d'une couche de résine photosensible au cours de son exposition à la lumière à travers un masque.

La figure 3 est une vue en coupe transfersale partielle d'une tranche de silicium recouverte d'une couche de résine photosensible, après le traitement avec le composé de silicium.

La figure 4 est une vue en coupe transversale partielle des motifs positifs obtenus après développement par gravure par ions réactifs d'oxygène ou par plasma d'oxygène.

Une large gamme de polymères peut être utilisée pour préparer la résine photosensible utilisée dans le procédé conforme à l'invention. Toutefois, de préférence, on utilise des polymères dont la chaîne polymère contient des groupes fonctionnels capables de réagir avec un composé de silicium, comme par exemple ceux portant des groupes OH, COOH, $SO_3H$, $NH_2$, NH, $CONH_2$, SH, etc. Des polymères particulièrement préférés sont les polymères phénoliques choisis parmi:

- les produits de condensation d'un phénol, d'un naphtol, ou d'un dérivé de ceux-ci, substitué sur le noyau par un radical alkyl ou aryle ou par un atome d'halogène, avec un aldéhyde aliphatique ou aromatique, substitué ou non par un atome d'halogène,
- les poly(vinylphénols) dont le groupe phénolique est substitué ou non par un radical alkyle ou aryle ou par un atome d'halogène,
- les copolymères d'un vinylphénol avec des composés éthyléniquement insaturés, et
- les mélanges des polymères précités entre eux ou avec d'autres polymères aromatiques, tels que le polystyrène ou le poly(N-vinylcarbazole).

Comme exemples illustratifs mais non limitatifs de polymères phénoliques, on citera notamment: les phénols-novolaques, les crésols-novolaques, les produits de condensation de formaldéhyde avec des alkylphénols (p-tert-butylphénol; p-n-propylphénol; p-éthylphénol; octylphénol; etc.), les produits de condensation de benzaldéhyde avec des crésols ou des naphtols (par exemple le 1-naphtol); les poly(p-vinylphénols), les copolymères de p-vinylphénols avec du p-chlorostyrène; etc.

L'agent de réticulation photosensible, mélangé ou lié chimiquement au polymère doit être capable de produire la réticulation du polymère par exposition à un rayonnement visible ou ultraviolet. Des agents de réticulation particulièrement préférés sont les bis-arylazides. En tant qu'exemples non limitatifs de ces bis-arylazides, on citera notamment: le 1,1'-(1,2-éthènediyl)bis[4-azidobenzène], la bis(4-azidophényl)cétone, la 2,6-bis[(4-azidophényl)méthylène]-cyclohexanone, la 2,6-bis[(4-azidophényl) méthylène]-4-méthyl-cyclohexanone, le 1,1'-sulfonylbis(3-azidobenzène), leurs dérivés et les mélanges d'au moins deux des composés précités.

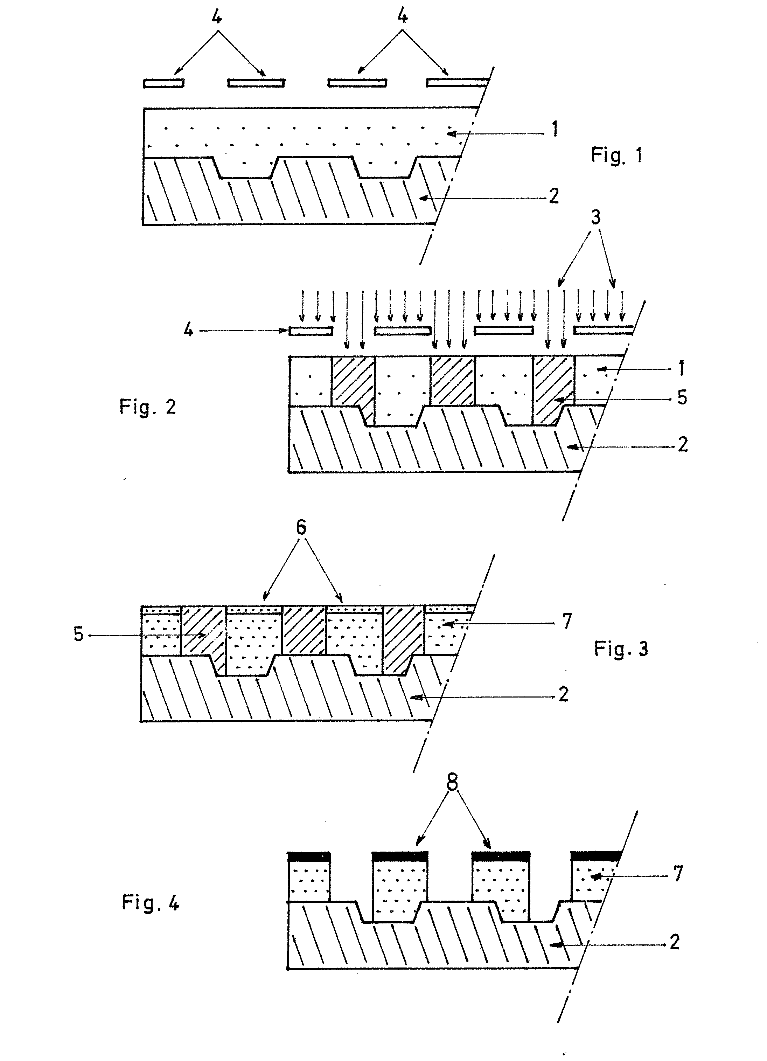

Ainsi qu'on le montre dans la figure 1, dans le premier stade du procédé de l'invention, une épaisse couche de résine photosensible (1) est appliquée sur une tranche de silicium ou substrat (2). Ce dépôt est en général effectué par enduction par centrifugation et à partir d'une solution diluée de la résine photosensible dans un solvant approprié. L'épaisseur de la couche de résine photosensible peut varier en fonction de la topographie du substrat. La présence du polymère dans la résine photosensible facilite la formation de surfaces bien égalisées et lisses sur le substrat.

Lorsque la résine photosensible est appliquée sur le substrat à partir d'une solution diluée dans un solvant, le solvant peut être choisi parmi une gamme étendue de produits dépendant des paramètres de solubilité, de la vitesse d'évaporation aux températures de traitement et des caractéristiques rhéologiques souhaitées. Des exemples de solvants pouvant être employés sont les suivants: cétones, esters, tels qu'acétates, propionates, etc...., éthers, éther esters, polyéthers, alcools, hydrocarbures aliphatiques ou aromatiques, tétrahydrofuranne, diméthylformamide, pyrrolidones, etc. La nature du solvant est sans rapport avec l'objet de la présente invention pour autant que l'on obtienne une solution ayant des propriétés filmogènes. La concentration de la solution dépend de l'épaisseur souhaitée de la couche de résine photosensible.

Après avoir été appliquée sur le substrat, la couche de résine photosensible (1) est en général séchée par cuisson pour éliminer le solvant. Les conditions utilisées pendant cette étape de cuisson ne sont pas critiques pour autant que le solvant soit efficacement éliminé et que l'on obtienne une surface exempte de collant. En pratique, on utilise des températures d'environ 50° à environ 150°C et, de préférence, d'environ 80 à 120°C. Le temps de cuisson peut être diminué lorsque la température de cuisson est augmentée. Le temps dépendra également de la facilité d'évaporation du solvant ou du mélange de solvants utilisé. Le temps de cuisson utilisé varie en pratique entre quelques secondes et 1 heure. Après cuisson, l'épaisseur de la couche de résine photosensible (1) est généralement comprise dans l'intervalle de 1 à 2,5 micromètres.

Ainsi qu'on le montre à la figure 2, le substrat (2) recouvert de la couche de résine photosensible (1) est ensuite exposé à un rayonnement visible ou ultraviolet (3) à travers un masque formateur d'images (4). La longueur d'onde du rayonnement appliqué est comprise entre 100 et 600 nm; toutefois, un rayonnement UV proche ayant une longueur d'onde d'environ 350 à 450 nm reçoit la préférence. Sous l'effet du rayonnement visible ou ultraviolet, les propriétés chimiques et physiques des parties irradiées (5) de la couche de résine photosensible subissent des modifications considérables par rapport aux parties non irradiées.

Typiquement, mais de manière non limitative, l'énergie du rayonnement appliquée peut varier entre 10 et 130 millijoules par centimètre carré, mesurée à une longueur d'onde de 400 nanomètres; la quantité d'énergie à appliquer dépend évidemment de la nature de la résine photosensible et du composé de silicium utilisés dans le stade suivant du procédé.

L'absorption de la lumière par la couche de résine photosensible peut éventuellement être accrue par l'addition de colorants spécifiques, comme décrit par M.M. O'TOOLE, E.D. LIU et M.S. CHANG dans Proc.SPIE Int.Soc.Opt. Eng.275,(1981) (Semicond.Microlithogr.VI), p.128-135 et par M. CHEN et coll. dans le brevet américain 4.362.809. Ces colorants doivent absorber d'une façon significative aux longueurs d'onde utilisées pour exposer la résine photosensible (100 à 600 nanomètres, de préférence 350-450 nanomètres), mais ils doivent être transparents dans une partie de la région visible pour rendre l'alignement possible au cours de l'exposition. Une concentration appropriée d'un tel colorant limitera l'exposition à une mince couche supérieure de la résine photosensible. On peut également ajouter des photosensibilisateurs ou d'autres agents similaires à la résine photosensible.

Comme il a déjà été expliqué plus haut, le traitement de la couche de résine photosensible par le composé de silicium peut être effectué pendant l'exposition à la lumière, mais de préférence après cette exposition, pour de simples raisons de facilité de manipulation. En outre, ce traitement peut être réalisé en phase liquide ou en phase vapeur. Selon une forme préférée de réalisation de l'invention, ce traitement est réalisé en phase vapeur. Ce dernier procédé est préféré parce qu'il permet l'utilisation de composés de silicium et plus particulièrement d'agents de silylation aisément vaporisables à des températures et des pressions appropriées.

A titre d'exemples non limitatifs de composés de silicium utilisables, on peut citer les agents de silylation suivants:
le tétrachlorosilane et les alkyl- et arylhalosilanes (par exemple le triméthylchlorosilane, le diméthyldichlorosilane, le méthyltrichlorosilane, le triméthylbromosilane, le triméthyliodosilane et le triphénylchlorosilane), les disilazanes (par exemple l'hexaméthyldisilazane, l'heptaméthyldisilazane, l'hexaphényldisilazane, le 1,3-bis(chlorométhyl)-1,1,3,3-tétraméthyldisilazane), le N-triméthylsilylimidazole, le N-triméthylsilylacétamide, la N-triméthylsilyldiméthylamine, la N-triméthylsilyldiéthylamine, l'hexaméthylsilanediamine, le N,O-bis(triéthylsilyl)acétimide, la N,N'-bis(triméthylsilyl(urée, la N,N'-diphényl-N-(triméthylsilyl)urée et les mélanges d'au moins deux de ces composés.

Le traitement de la couche de résine photosensible par le composé de silicium peut être effectué dans une chambre de réaction séparée ou dans un équipement de déplacement de tranches pas-à-pas.

Le traitement par le composé de silicium produit, comme déjà indiqué précédemment, la diffusion sélective du composé de silicium dans les parties non irradiées (7) de la couche; ce composé se fixe ensuite dans ces parties en réagissant avec les groupes fonctionnels de la résine, en particulier avec les groupes fonctionnels du polymère. Par contre, dans les parties irradiées (5), on ne constate pratiquement pas de diffusion du composé de silicium ou uniquement de manière insignifiante en surface. L'incorporation du composé de silicium se fait donc uniquement dans les parties non irradiées (7) de la couche et non dans les parties irradiées de celle-ci.

Comme le montre la figure 3, l'incorporation du composé de silicium peut avantageusement être limitée à la partie supérieure (6) des parties non irradiées (7) de la couche de résine photosensible.

L'épaisseur de la couche contenant du silicium est régie par les lois de diffusion et variera en fonction de la nature du composé de silicium et de sa concentration et de la composition de la résine photosensible. Pour un système donné, elle dépendra de la durée, de la température et de la pression du traitement et, par conséquent, elle peut être orientée dans le sens voulu par des paramètres aisément contrôlables.

Etant donné que la formation des images peut se produire dans une couche plane très mince à la partie supérieure du photorésist, on peut obtenir des images de qualité par une impression par projection classique avec de la lumière étroitement focalisée. Il suffira, en effet, de limiter l'exposition à la lumière UV à une mince couche à la partie supérieure de la résine photosensible, de manière à ce que la lumière soit suffisamment éteinte par absorption dans la partie restante de la couche avant qu'il ne se produise une interférence de lumière réfléchie. Il en résulte que les problèmes, tels que les ondes stationnaires et les variations de la largeur des lignes sur des gradins fortement réfléchissants, comme par exemple des interconnecteurs métalliques, sont éliminés.

Le traitement de la couche de résine photosensible par le composé de silicium est effectué à une température appropriée qui dépend de la composition de la résine photosensible, de la nature du composé de silicium utilisé et de la concentration de ce dernier, de même que de la durée du traitement; cette température est choisie de manière à ce qu'une diffusion sélective du composé de silicium ait lieu dans les parties non irradiées de la résine; elle peut être choisie entre la température de vaporisation du composé de silicium (qui dépend elle-même de la pression régnant dans le système qui peut aller d'un vide relatif à plusieurs bars) et la température de décomposition thermique des constituants de la résine photosensible. En pratique, la température de ce traitement peut varier entre 0 et 250°C,. et de préférence entre 80 et 180°C.

La durée du traitement par le composé de silicium n'est pas critique; elle dépend essentiellement de la température, et accessoirement de la nature de la résine photosensible, du composé de silicium et de la concentration de ce dernier. En pratique, cette durée peut varier entre quelques secondes et une heure, et de préférence entre 1 et 45 minutes.

Après le traitement de la résine photosensible par le composé de silicium, on peut éliminer l'excès de ce dernier pour des raisons de facilité de manipulation ultérieure; cette élimination se fait de préférence par évaporation sous vide. Il n'est toutefois pas indispensable d'éliminer l'excès de composé de silicium, les qualités des motifs obtenus par le procédé de l'invention étant tout aussi bonnes sans élimination de l'excès de composé de silicium, qu'avec son élimination; ceci s'explique par le fait que le composé de silicium ne diffuse pratiquement pas dans les parties irradiées de la résine photosensible et que ces parties sont par conséquent facilement enlevées par le développement ultérieur par gravure sèche par plasma d'oxygène ou par ions réactifs d'oxygène.

Au dernier stade du procédé de l'invention, la couche de résine photosensible traitée comme décrit ci-dessus, est développée par voie sèche en utilisant, de préférence, une technique de gravure par plasma d'oxygène ou par ions réactifs d'oxygène. Ces techniques, de même que l'appareillage utilisé pour leur mise en oeuvre, sont bien connus de l'homme de métier et il n'est pas nécessaire de les décrire en détail.

Ainsi qu'on le montre à la figure 4, le développement par gravure sèche a pour conséquence que les parties irradiées du photorésist sont rapidement enlevées, tandis que les parties non irradiées (7) résistent parfaitement grâce à la formation in situ d'un masque d'oxyde de silicium (8).

Lorsque les parties irradiées sont complètement éliminées jusqu'à la surface du substrat (2), on obtient des motifs positifs d'excellente qualité qui présentent des parois latérales verticales, une haute résolution, pas de variation mesurable dans la largeur des lignes sur les gradins et un rapport d'aspect élevé. De plus, on obtient des surfaces exemptes de résidu dans les zones dénudées.

L'exemple suivant illustre l'invention sans toutefois la limiter. Dans cet exemple, la valeur indiquée pour l'énergie du rayonnement UV est déterminée à une longueur d'onde de 400 nanomètres.

Exemple.

En tant que substrat, on utilise des tranches de silicium recouvertes d'un oxyde thermique d'environ 120 nanomètres d'épaisseur.

En tant que résine photosensible, on utilise un mélange de 25 g de poly(p-vinylphénol) et de 1 g de 2,6-bis[(4-azidophényl)méthylène]-4-méthylcyclohexanone que l'on dissout dans 100 g d'acétate de 2-éthoxyéthyle.

Cette solution est enduite par centrifugation sur les tranches de silicium à une vitesse de rotation de 4000 tours par minute. De cette manière, on obtient sur chaque tranche une couche de résine de 1,3 micromètre d'épaisseur.

Les tranches ainsi enduites sont cuites sur une plaque chauffante à 95°C pendant 45 secondes. Puis, on les soumet à une exposition aux rayons ultraviolets, à travers un masque, dans un équipement conventionnel produisant de la lumière UV dont la longueur d'onde est comprise entre 350 et 450 nm; l'énergie du rayonnement est de 45 mJ/cm$^2$.

On traite ensuite les tranches ainsi exposées avec des vapeurs d'hexaméthyldisilazane à 150°C pendant 5 minutes.

Après développement par gravure par ions réactifs d'oxygène, on obtient des motifs positifs présentant une haute résolution.

**Revendications**

1. Procédé de formation de motifs positifs dans une couche de photorésist caractérisé en ce qu'il comprend les stades suivants:

(a) le recouvrement d'un substrat par une couche de résine photosensible comprenant un polymère porteur de groupes fonctionnels, mélangé ou lié chimiquement à un agent de réticulation photosensible, ladite résine photosensible étant telle que par un rayonnement visible ou ultraviolet, les parties irradiées de la couche subissent une réticulation qui supprime substantiellement la perméabilité desdites parties;

(b) l'exposition à la lumière ultraviolette ou visible de la couche de résine photosensible à travers un masque de façon à ce que seules les parties voulues de la couche soient exposées et à ce que sa perméabilité soit substantiellement supprimée dans lesdites parties;

(c) Le traitement de la couche de résine photosensible par un composé de silicium, de manière à ce que ce composé soit sélectivement absorbé dans les parties non irradiées de la couche et entre en réaction avec la résine photosensible dans lesdites parties non irradiées; et

(d) Le développement par voie sèche par gravure au plasma de la couche de résine photosensible ainsi traitée, de manière à enlever sélectivement les parties irradiées de celle-ci pour obtenir les motifs positifs souhaités.

2. Procédé selon la revendication 1, caractérisé en ce que l'agent de réticulation photosensible est un bis-arylazide.

3. Procédé selon la revendication 2, caractérisé en ce que le bis-arylazide est choisi dans le groupe consistant en le 1,1'-(1,2-éthènediyl) bis[4-azidobenzène], la bis(4-azidophényl)cétone, la 2,6-bis[(4-azidophényl) méthylène]-cyclohexanone, la 2,6-bis[(4-azidophényl)méthylène]-4-méthylcyclohexanone, le 1,1'-sulfonyl-bis(3-azidobenzène), leurs dérivés et les mélanges d'au moins deux des composés précités.

4. Procédé selon l'une quelconque des revendications 1 à 3, caractérisé en ce que le polymère porteur de groupes fonctionnels est un polymère phénolique.

5. Procédé selon la revendication 4, caractérisé en ce que le polymère phénolique est choisi parmi

- les produits de condensation d'un phénol ou d'un naphtol, ou d'un dérivé de ceux-ci, substitué sur le noyau par un radical alkyle ou aryle ou par un atome d'halogène, avec un aldéhyde aliphatique ou aromatique, substitué ou non par un atome d'halogène,
- les poly(vinylphénols) dont le groupe phénolique est substitué ou non par un radical alkyl ou aryle ou par un atome d'halogène,
- les copolymères d'un vinylphénol avec des composés éthyléniquement insaturés, et
- les mélanges des polymères précités entre eux ou avec d'autres polymères aromatiques.

6. Procédé selon l'une quelconque des revendications 1 à 5, caractérisé en ce que la résine photosensible comprend en outre un colorant.

7. Procédé selon l'une quelconque des revendications 1 à 6, caractérisé en ce que la couche de résine photosensible est exposée à la lumière ultraviolette proche ayant une longueur d'onde d'environ 350 à 450 nanomètres.

8. Procédé selon l'une quelconque des revendications 1 à 7, caractérisé en ce que le composé de silicium est un agent de silylation facilement vaporisable.

9. Procédé selon l'une quelconque des revendications 1 à 8, caractérisé en ce que le composé de silicium est mis en contact sous forme de vapeurs avec le couche de résine photosensible.

10. Procédé selon l'une quelconque des revendications 1 à 9, caractérisé en ce que le composé de silicium est un agent de silylation choisi parmi le tétrachlorosilane, le triméthylchlorosilane, le diméthyldichlorosilane, le méthyltrichlorosilane, le triméthylbromosilane, le triméthyliodosilane, le triphénylchlorosilane, l'hexaméthyldisilazane, l'heptaméthyldisilazane, l'hexaphényldisilazane, le 1,3-bis(chlorométhyl)-1,1,3,3-tétraméthyldisilazane, le N-triméthylsilylimidazole, le N-triméthylsilylacétamide, la N-triméthylsilyldiméthylamine, la N-triméthylsilyldiéthylamine, l'hexaméthylsilanediamine, le N,O-bis(triéthylsilyl)acétimide, la N,N'- bis(triméthylsilyl)urée, la N,N'-diphényl-N-(triméthylsilyl)urée et les mélanges d'au moins deux de ces composés.

11. Procédé selon le revendication 10, caractérisé en ce que l'agent de silylation est l'hexaméthyldisilazane.

12. Procédé selon l'une quelconque des revendications 1 à 11, caractérisé en ce que le traitement de la couche de résine photosensible par le composé de silicium est effectué à une température comprise entre 0 et 250°C.

13. Procédé selon la revendication 12, caractérisé en ce que le traitement de la couche de résine photosensible par le composé de silicium est effectué à une température comprise entre 80 et 180°C.

14. Procédé selon l'une quelconque des revendications 1 à 13, caractérisé en ce que la durée du traitement de la couche de résine photosensible par le composé de silicium est comprise entre quelques secondes et une heure.

15. Procédé selon la revendication 14, caractérisé en ce que la durée du traitement de la couche de résine photosensible par le composé de silicium est comprise entre 1 et 45 minutes.

16. Procédé selon l'une quelconque des revendications 1 à 15, caractérisé en ce que le développement par voie sèche est effectué par gravure au plasma d'oxygène ou par ions réactifs d'oxygène.

17. Utilisation du procédé selon l'une quelconque des revendications 1 à 16 pour la fabrication de circuits semi-conducteurs intégrés.

0248779

Fig. 1

Fig. 2

Fig. 3

Fig. 4

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X,Y D | JOURNAL OF THE ELECTROCHEMICAL SOCIETY, vol. 131, no. 7, juillet 1984, pages 1664-1670, Manchester, New Hampshire, US; T.M. WOLF et al.: "The scope and mechanism of new positive tone gas-phase-functionalized plasma-developed resists" * En entier * | 1-17 | G 03 F   7/26 |
| X | EP-A-0 136 130   (AMERICAN TELEPHONE AND TELEGRAPH CO.) * Revendications 4,8 * | 1-17 | |
| Y | PATENT ABSTRACTS OF JAPAN, vol. 8, no. 167 (E-258)[1604, 2 août 1984; & JP-A-59 61 928 (HITACHI SEISAKUSHO K.K.) 09-04-1984 | 7-17 | |
| Y | EXTENDED ABSTRACTS, vol. 82, no. 2, octobre 1982, page 321-322, New Jersey, US; D. FOLLETT et al.: "Polarity reversal of PMMA by treatment with chlorosilanes" * En entier * | 8-13 | DOMAINES TECHNIQUES RECHERCHES (Int. Cl.4) G 03 F   7/26 |
| Y | EP-A-0 040 535   (HITACHI) * Revendications * | 2-6 | |
| Y | EP-A-0 083 078   (HITACHI) * Revendications * -/- | 2-6 | |

Le présent rapport de recherche a été établi pour toutes les revendications

| Lieu de la recherche LA HAYE | Date d'achèvement de la recherche 07-09-1987 | Examinateur RASSCHAERT A. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82

## DOCUMENTS CONSIDERES COMME PERTINENTS

Page 2

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A-2 079 481 (RCA)<br>* Revendications *<br><br>--- | 2-6 | |
| A | EP-A-0 135 900 (P.A. HUNT)<br>* Revendications *<br><br>--- | 2-6 | |
| A | US-A-4 465 768 (TAKUMI VENO)<br>* Revendications *<br><br>--- | 2-6 | |
| A | MICROCIRCUIT ENGINEERING, 1983, pages 381-388, Academic Press, Londres, GB; D. FAUVEL et al.: "Study of some plasma developable resists"<br>* En entier *<br><br>--- | 1 | |
| P,X | EP-A-0 204 253 (IBM)<br>* En entier *<br><br>--- | 1-17 | DOMAINES TECHNIQUES RECHERCHES (Int. Cl.4) |
| A | EP-A-0 161 476 (IBM)<br>* Revendications *<br><br>----- | 1-17 | |

Le présent rapport de recherche a été établi pour toutes les revendications

| Lieu de la recherche | Date d'achèvement de la recherche | Examinateur |
|---|---|---|
| LA HAYE | 07-09-1987 | RASSCHAERT A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur. mais publié à la date de dépôt ou après cette date
D : cité dans la demande
L : cité pour d'autres raisons

& : membre de la même famille, document correspondant

OEB Form 1503 03 82